# EUROPEAN PATENT APPLICATION

(11) **EP 4 398 312 A1**
(43) Date of publication of application: **10.07.2024**
(21) Application number: 22915026.3
(22) Date of filing: 29.12.2022
(51) Int. Cl.: H01L 31/0216

(54) **SOLAR CELL FRONT PASSIVATION FILM LAYER**

(30) Priority: 30.12.2021 CN 202123386649 U
(71) Applicant: Trina Solar Co., Ltd, Changzhou, Jiangsu 213031 (CN)
(72) Inventor: ZUO, Jingwu, Changzhou, Jiangsu 213031 (CN); LU, Yugang, Changzhou, Jiangsu 213031 (CN); CHANG, Yongsheng, Changzhou, Jiangsu 213031 (CN); ZHUO, Qidong, Changzhou, Jiangsu 213031 (CN); ZHANG, Yanyan, Changzhou, Jiangsu 213031 (CN); HE, Quangui, Changzhou, Jiangsu 213031 (CN); CHEN, Hong, Changzhou, Jiangsu 213031 (CN)
(74) Representative: Canzler & Bergmeier Patentanwälte Partnerschaft mbB
(86) International application number: PCT/CN2022/143291
(87) International publication number: WO 2023/125776

(57) **Abstract**

The present invention provides a solar cell front passivation film layer. The solar cell front passivation film layer comprises a silicon substrate, on the surface of which are sequentially laminated with a first silicon nitride layer, a second silicon nitride layer and a silicon oxynitride layer, refractive indexes of the first silicon nitride layer, the second silicon nitride layer and the silicon oxynitride layer being gradually reduced, and the thickness of the silicon oxynitride layer ranging from 40 nm to 60 nm. According to the solar cell front passivation film layer provided in the present invention, under a condition that the thickness of the silicon oxynitride film layer is large, an excellent passivation effect can be guaranteed, and the reflectivity of the solar cell front passivation film layer can be reduced, so that the optical reflectivity of a cell and an assembly is reduced. In addition, the cell and the assembly prepared by the solar cell front passivation film layer provided in the present invention are darker and more uniform in color, and have higher sunlight absorption efficiency, so that the efficiency and power of the cell and the assembly are higher.

## Description

### TECHNICAL FIELD

The present disclosure belongs to the technical field of solar cells, and particularly relates to a solar cell front passivation film layer.

### BACKGROUND

Solar cells have great potential in the field of power generation, and the solar cell manufactured from crystalline silicon is a mainstream technology in the photovoltaic industry for the coming years. In scale production, an antireflection film is typically deposited on a surface of a silicon wafer to increase the utilization rate of light, and thus increase a conversion efficiency of the cell. The plasma enhanced chemical vapor deposition (PECVD) process, which can be used to prepare a film layer of good uniformity and high compactness and prepare different film layer structures by adjusting the type, flow rate and the like of a special gas, has become a main film coating mode in the preparation process of solar cells.

Most solar cell front passivation film layers currently used are silicon nitride film layers including silicon nitride, which has good dielectric properties (low dielectric constant and low loss), high insulation and high compactness, and can well block impurity ions. However, the optical reflectivity of the silicon nitride film layer is relatively high, and is difficult to be reduced to 2.0 or less, while further improvement of the cell efficiency may be limited by the high combination interface state and the extinction property of the silicon nitride film layer and the silicon substrate. At present, the application of the silicon oxynitride film layer in the solar cell can reduce the optical reflectivity of the silicon nitride film layer, but the passivation effect is poor, which limits increase of the thickness of the silicon oxynitride film layer.

CN106449788A discloses a multilayer antireflection coating of a crystalline silicon cell. The multilayer antireflection coating is deposited on an N-type surface of the crystalline silicon cell and includes a silicon oxide film, a first silicon nitride film, a second silicon nitride film, a third silicon nitride film, a fourth silicon nitride film, and a zirconium dioxide barrier layer sequentially arranged from bottom to top. The multilayer antireflection coating of the crystalline silicon cell has the advantages of fast short wave response and excellent light permeability, and the existence of the zirconium dioxide barrier layer improves the resistance to potential-induced attenuation of the crystalline silicon cell.

CN110391304A discloses a solar cell multilayer antireflection grading film and a preparation process thereof. The solar cell multilayer antireflection grading film includes a first silicon nitride film, a second silicon nitride film, a first silicon oxynitride film, a second silicon oxynitride film, and a silicon oxide film sequentially arranged from bottom to top, and the refractive indexes of the films are reduced layer by layer from bottom to top. In the solar cell multilayer antireflection grading film, each of the silicon oxynitride film layers has a thickness of 3 to 15 nm, so as to reduce a front reflectivity of the solar cell while ensuring a good passivation effect.

CN106549065A discloses a low-reflectivity film layer structure, including a silicon wafer, where a front texture is formed on a front surface of the silicon wafer and provided with an amorphous silicon film layer, a bottom high-refractivity film layer, a middle high-refractivity film layer, and a surface grading film layer sequentially arranged from bottom to top, and the surface grading film layer is provided with a surface low-refractivity film layer. The surface low-refractivity film layer is a silicon dioxide layer, a silicon oxynitride layer, or a titanium dioxide layer, with a thickness of merely 5 to 10 nm. Through cooperation of the amorphous silicon film layer, the bottom high-refractivity film layer, the middle high-refractivity film layer, and the surface grading film layer, the low-reflectivity film layer can reduce the reflectivity and improve the conversion efficiency of the cell.

These documents all effectively reduce the reflectivity of the solar cell front passivation film, but fail to solve the problem of ensuring an excellent passivation effect of the silicon oxynitride film layer under the condition of a thick silicon oxynitride film layer, thereby limiting further reduction of the reflectivity of solar cell front passivation film. Therefore, there is an urgent need for developing a novel solar cell front passivation film layer structure.

### SUMMARY

Aiming at the defects in the existing art, an object of the present disclosure is to provide a solar cell front passivation film layer which, with a relatively thick silicon oxynitride film layer, can not only guarantee an excellent passivation effect, but also reduce the reflectivity of the solar cell front passivation film layer, thereby reducing the optical reflectivities of the cell and the assembly. In addition, the cell and the assembly prepared by the solar cell front passivation film layer of the present disclosure have darker and more uniform colors and higher sunlight absorption efficiency, thereby enabling higher efficiency and power of the cell and the assembly.

In order to achieve this object, the present disclosure adopts the following technical solutions:

The present disclosure provides a solar cell front passivation film layer, including a silicon substrate, on a surface of which are sequentially laminated a first silicon nitride layer, a second silicon nitride layer and a silicon oxynitride layer, wherein refractive indexes of the first silicon nitride layer, the second silicon nitride layer and the silicon oxynitride layer are gradually reduced.

The silicon oxynitride layer has a thickness of 40 nm to 60 nm, for example, 40 nm, 42 nm, 44 nm, 46 nm, 48 nm, 50 nm, 52 nm, 54 nm, 56 nm, 58 nm or 60 nm, but is not limited to the recited values, and other values not recited in this range are also applicable.

According to the solar cell front passivation film layer provided in the present disclosure, by plating the relatively thick silicon oxynitride layer with a low refractive index on the outermost layer of the passivation film layer, and by process optimization (changing the special gas flow rate ratio and the power), the passivation performance of the silicon oxynitride layer is improved, and refractive indexes of the first silicon nitride layer, the second silicon nitride layer and the silicon oxynitride layer are gradually reduced, so that the problem of light loss caused by optical mismatch due to a large refractive index difference over the solar cell front passivation layer is solved, and thus a solar cell front passivation layer with excellent passivation performance and a lower optical reflectivity is obtained.

The solar cell front passivation film layer according to the present disclosure, under the condition of the relatively thick silicon oxynitride film layer, can not only guarantee an excellent passivation effect, but also reduce the reflectivity of the solar cell front passivation film layer, thereby reducing the optical reflectivities of the cell and the assembly. In addition, the cell and the assembly prepared by the solar cell front passivation film layer of the present disclosure have darker and more uniform colors and higher sunlight absorption efficiency, thereby enabling higher efficiency and power of the cell and the assembly.

As an optional technical solution of the present disclosure, the silicon oxynitride layer has a refractive index of 1.4 to 1.9, for example, 1.4, 1.45, 1.5, 1.55, 1.6, 1.65, 1.7, 1.75, 1.8, 1.85 or 1.9, but is not limited to the recited values, and other values not recited in this range are also applicable.

As an optional technical solution of the present disclosure, the first silicon nitride layer has a refractive index of 2.15 to 2.4, for example, 2.15, 2.17, 2.2, 2.23, 2.25, 2.27, 2.3, 2.32, 2.35, 2.38 or 2.4, but is not limited to the recited values, and other values not recited in this range are also applicable.

As an optional technical solution of the present disclosure, the second silicon nitride layer has a refractive index of 1.98 to 2.2, for example, 1.98, 2, 2.02, 2.04, 2.06, 2.08, 2.1, 2.12, 2.14, 2.16, 2.18 or 2.2, but is not limited to the recited values, and other values not recited in this range are also applicable.

As an optional technical solution of the present disclosure, the first silicon nitride layer has a thickness less than the second silicon nitride layer.

As an optional technical solution of the present disclosure, the first silicon nitride layer has a thickness of 5 nm to 15 nm, for example, 5 nm, 6 nm, 7 nm, 8 nm, 9 nm, 10 nm, 11 nm, 12 nm, 13 nm, 14 nm or 15 nm, but is not limited to the recited values, and other values not recited in this range are also applicable.

The second silicon nitride layer has a thickness of 20 nm to 40 nm, for example, 20 nm, 22 nm, 24 nm, 26 nm, 28 nm, 30 nm, 32 nm, 34 nm, 36 nm, 38 nm or 40 nm, but is not limited to the recited values, and other values not recited in this range are also applicable.

As an optional technical solution of the present disclosure, a silicon oxide layer is disposed between the silicon substrate and the first silicon nitride layer.

In the present disclosure, since a silicon oxide (SiOx) layer is disposed between the silicon substrate and the first silicon nitride layer, in combination with relatively low interface state and refractive indexes of the silicon oxide layer and the silicon substrate, a good surface passivation effect can be provided, so that the passivation performance of the solar cell front passivation film layer can be further improved, the reflectivity of the solar cell front passivation film layer can be reduced, and thus the efficiency of the cell and the assembly can be further increased.

As an optional technical solution of the present disclosure, the silicon oxide layer has a thickness of 3 nm to 15 nm, for example, 3 nm, 4 nm, 5 nm, 6 nm, 7 nm, 8 nm, 9 nm, 10 nm, 11 nm, 12 nm, 13 nm, 14 nm or 15 nm, but is not limited to the recited values, and other values not recited in this range are also applicable.

As an optional technical solution of the present disclosure, a third silicon nitride layer is disposed between the second silicon nitride layer and the silicon oxynitride layer.

As an optional technical solution of the present disclosure, the third silicon nitride layer has a refractive index of 1.8 to 2.05, for example, 1.8, 1.82, 1.85, 1.88, 1.9, 1.92, 1.95, 1.98, 2, 2.02 or 2.05, but is not limited to the recited values, and other values not recited in this range are also applicable.

In the present disclosure, the refractive indexes of the silicon nitride layers may satisfy: refractive index of the first silicon nitride layer > refractive index of the second silicon nitride layer > refractive index of the third silicon nitride layer.

The third silicon nitride layer has a thickness of 15 nm to 40 nm, for example, 15 nm, 18 nm, 20 nm, 23 nm, 25 nm, 28 nm, 30 nm, 32 nm, 35 nm, 38 nm or 40 nm, but is not limited to the recited values, and other values not recited in this range are also applicable.

The relationship between the thickness of the second silicon nitride layer and the thickness of the third silicon nitride layer is not limited in the present disclosure.

It should be noted that the present disclosure provides two technical solutions for a solar cell front passivation film layer structure.

Technical Solution 1: a solar cell front passivation film layer, including a silicon substrate, on a surface of which are sequentially laminated a first silicon nitride layer, a second silicon nitride layer and a silicon oxynitride layer, where refractive indexes of the first silicon nitride layer, the second silicon nitride layer and the silicon oxynitride layer are gradually reduced.

In other words, the solar cell front passivation film layer may include a silicon substrate, a first silicon nitride layer, a second silicon nitride layer, and a silicon oxynitride layer, where the first silicon nitride layer, the second silicon nitride layer, and the silicon oxynitride layer are sequentially laminated on a surface of the silicon substrate. That is, the first silicon nitride layer is laminated on a surface of the silicon substrate, the second silicon nitride layer is laminated on a surface of the first silicon nitride layer facing away from the silicon substrate, and the silicon oxynitride layer is laminated on a surface of the second silicon nitride layer facing away from the first silicon nitride layer. Further, refractive indexes of the first silicon nitride layer, the second silicon nitride layer and the silicon oxynitride layer are gradually reduced layer by layer. That is, the refractive index of the second silicon nitride layer is smaller than the refractive index of the first silicon nitride layer, and the refractive index of the silicon oxynitride layer is smaller than the refractive index of the second silicon nitride layer.

Technical Solution 2: a solar cell front passivation film layer, including a silicon substrate, on a surface of which are sequentially laminated a silicon oxide layer, a first silicon nitride layer, a second silicon nitride layer, a third silicon nitride layer, and a silicon oxynitride layer, where refractive indexes of the first silicon nitride layer, the second silicon nitride layer, the third silicon nitride layer and the silicon oxynitride layer are gradually reduced.

In other words, the solar cell front passivation film layer may include a silicon substrate, a silicon oxide layer, a first silicon nitride layer, a second silicon nitride layer, a third silicon nitride layer, and a silicon oxynitride layer, where the silicon oxide layer, the first silicon nitride layer, the second silicon nitride layer, the third silicon nitride layer and the silicon oxynitride layer are sequentially laminated on a surface of the silicon substrate. That is, the silicon oxide layer is laminated on a surface of the silicon substrate, the first silicon nitride layer is laminated on a surface of the silicon oxide layer facing away from the silicon substrate, the second silicon nitride layer is laminated on a surface of the first silicon nitride layer facing away from the silicon oxide layer, the third silicon nitride layer is laminated on a surface of the second silicon nitride layer facing away from the first silicon nitride layer, and the silicon oxynitride layer is laminated on a surface of the third silicon nitride layer facing away from the second silicon nitride layer. Further, refractive indexes of the first silicon nitride layer, the second silicon nitride layer, the third silicon nitride layer and the silicon oxynitride layer are gradually reduced layer by layer. That is, the refractive index of the second silicon nitride layer is smaller than the refractive index of the first silicon nitride layer, the refractive index of the third silicon nitride layer is smaller than the refractive index of the second silicon nitride layer, and the refractive index of the silicon oxynitride layer is smaller than the refractive index of the third silicon nitride layer.

It should be noted that the materials used in the present disclosure are all known in the art.

Compared with the existing art, the present disclosure has the following beneficial effects:
the solar cell front passivation film layer according to the present disclosure, under the condition of a relatively thick silicon oxynitride film layer, can not only guarantee an excellent passivation effect, but also reduce the reflectivity of the solar cell front passivation film layer, thereby reducing the optical reflectivities of the cell and the assembly. In addition, the cell and the assembly prepared by the solar cell front passivation film layer of the present disclosure have darker and more uniform colors and higher sunlight absorption efficiency, thereby enabling higher efficiency and power of the cell and the assembly.

### BRIEF DESCRIPTION OF DRAWINGS

FIG. 1 is a schematic structural diagram of a solar cell front passivation film layer according to embodiments 1 to 3 of the present disclosure; and
FIG. 2 is a schematic structural diagram of a solar cell front passivation film layer according to embodiments 4 to 6 of the present disclosure.

### List of reference numerals:

1 - silicon substrate; 2 - first silicon nitride layer; 3 - second silicon nitride layer; 4 - silicon oxynitride layer; 5 - silicon oxide layer; and 6 - third silicon nitride layer.

### DETAIL DESCRIPTION OF EMBODIMENTS

It is to be understood that in the description of the present disclosure, the terms "central," "longitudinal," "lateral," "upper," "lower," "front," "rear," "left," "right," "vertical," "horizontal," "top," "bottom," "inner," "outer," and the like are based on the orientations or positional relationships shown in the drawings, and are merely for the purposes of describing the present disclosure and simplifying the description, instead of indicting or implying that the device or component referred to must have a specific orientation or be configured or operated at a specific orientation, and thus should not be interpreted as limitations to the present disclosure. Furthermore, the terms "first," "second," and the like are used for descriptive purposes only and are not to be construed as indicating or implying relative importance or to implicitly indicate a number of the indicated technical features. Therefore, a feature defined by "first," "second" and the like may include one or more of the indicated feature either explicitly or implicitly. In the description of the present disclosure, "a plurality" means two or more unless otherwise specified.

It should be noted that, unless explicitly stated or defined otherwise, the terms "disposed," "connected" and "connect" in the description of the present disclosure are to be construed broadly and may include, for example, fixed connection, detachable connection, or integral connection; or may include mechanical or electrical connection; or may include direct connection, indirect connection via an intermedium, or internal communication between two elements. The specific meanings of the above terms in the present disclosure may be understood by those of ordinary skill in the art as the case may be.

The technical solution of the present disclosure is further explained below with specific implementations in combination with the attached drawings.

### Embodiment 1

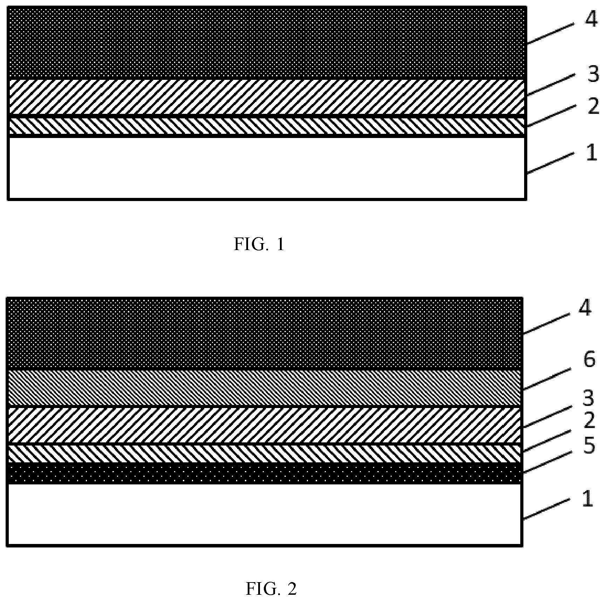

This embodiment provides a solar cell front passivation film layer which, as shown in FIG. 1, includes a silicon substrate 1, on a surface of which are sequentially laminated a first silicon nitride layer 2, a second silicon nitride layer 3 and a silicon oxynitride layer 4. The first silicon nitride layer 2 has a refractive index of 2.3 and a thickness of 10 nm; the second silicon nitride layer 3 has a refractive index of 2.1 and a thickness of 30 nm; and the silicon oxynitride layer 4 has a refractive index of 1.6 and a thickness of 50 nm.

### Embodiment 2

This embodiment provides a solar cell front passivation film layer which, as shown in FIG. 1, includes a silicon substrate 1, on a surface of which are sequentially laminated a first silicon nitride layer 2, a second silicon nitride layer 3 and a silicon oxynitride layer 4. The first silicon nitride layer 2 has a refractive index of 2.15 and a thickness of 15 nm; the second silicon nitride layer 3 has a refractive index of 1.98 and a thickness of 40 nm; and the silicon oxynitride layer 4 has a refractive index of 1.4 and a thickness of 60 nm.

### Embodiment 3

This embodiment provides a solar cell front passivation film layer which, as shown in FIG. 1, includes a silicon substrate 1, on a surface of which are sequentially laminated a first silicon nitride layer 2, a second silicon nitride layer 3 and a silicon oxynitride layer 4. The first silicon nitride layer 2 has a refractive index of 2.4 and a thickness of 5 nm; the second silicon nitride layer 3 has a refractive index of 2.2 and a thickness of 20 nm; and the silicon oxynitride layer 4 has a refractive index of 1.9 and a thickness of 40 nm.

### Embodiment 4

This embodiment provides a solar cell front passivation film layer which, as shown in FIG. 2, includes a silicon substrate 1, on a surface of which are sequentially laminated a silicon oxide layer 5, a first silicon nitride layer 2, a second silicon nitride layer 3, a third silicon nitride layer 6, and a silicon oxynitride layer 4. The silicon oxide layer 5 has a thickness of 10 nm; the first silicon nitride layer 2 has a refractive index of 2 and a thickness of 12 nm; the second silicon nitride layer 3 has a refractive index of 1.98 and a thickness of 40 nm; the third silicon nitride layer 6 has a refractive index of 1.9 and a thickness of 25 nm; and the silicon oxynitride layer 4 has a refractive index of 1.7 and a thickness of 45 nm.

### Embodiment 5

This embodiment provides a solar cell front passivation film layer which, as shown in FIG. 2, includes a silicon substrate 1, on a surface of which are sequentially laminated a silicon oxide layer 5, a first silicon nitride layer 2, a second silicon nitride layer 3, a third silicon nitride layer 6, and a silicon oxynitride layer 4. The silicon oxide layer 5 has a thickness of 3 nm; the first silicon nitride layer 2 has a refractive index of 2.3 and a thickness of 8 nm; the second silicon nitride layer 3 has a refractive index of 2.15 and a thickness of 25 nm; the third silicon nitride layer 6 has a refractive index of 2.05 and a thickness of 15 nm; and the silicon oxynitride layer 4 has a refractive index of 1.5 and a thickness of 55 nm.

### Embodiment 6

This embodiment provides a solar cell front passivation film layer which, as shown in FIG. 2, includes a silicon substrate 1, on a surface of which are sequentially laminated a silicon oxide layer 5, a first silicon nitride layer 2, a second silicon nitride layer 3, a third silicon nitride layer 6, and a silicon oxynitride layer 4. The silicon oxide layer 5 has a thickness of 15 nm; the first silicon nitride layer 2 has a refractive index of 2.3 and a thickness of 10 nm; the second silicon nitride layer 3 has a refractive index of 2.1 and a thickness of 30 nm; the third silicon nitride layer 6 has a refractive index of 1.8 and a thickness of 40 nm; and the silicon oxynitride layer 4 has a refractive index of 1.6 and a thickness of 50 nm.

The applicant declares that the above are merely specific implementations of the present disclosure, and the scope of the present disclosure is not limited thereto. Those skilled in the art shall understand that any changes or substitutions that can be easily conceived by those skilled in the art within the technical scope of the present disclosure disclosed herein fall within the protection scope and disclosure of the present disclosure.

## Claims

1. A solar cell front passivation film layer, **characterized in that** the solar cell front passivation film layer comprises a silicon substrate, on a surface of which are sequentially laminated a first silicon nitride layer, a second silicon nitride layer and a silicon oxynitride layer, wherein refractive indexes of the first silicon nitride layer, the second silicon nitride layer and the silicon oxynitride layer are gradually reduced; and
the silicon oxynitride layer has a thickness of 40 nm to 60 nm.

2. The solar cell front passivation film layer according to claim 1, **characterized in that** the silicon oxynitride layer has a refractive index of 1.4 to 1.9.

3. The solar cell front passivation film layer according to claim 1, **characterized in that** the first silicon nitride layer has a refractive index of 2.15 to 2.4.

4. The solar cell front passivation film layer according to claim 1, **characterized in that** the second silicon nitride layer has a refractive index of 1.98 to 2.2.

5. The solar cell front passivation film layer according to claim 1, **characterized in that** the first silicon nitride layer has a thickness less than the second silicon nitride layer.

6. The solar cell front passivation film layer according to claim 1, **characterized in that** the first silicon nitride layer has a thickness of 5 nm to 15 nm, and the second silicon nitride layer has a thickness of 20 nm to 40 nm.

7. The solar cell front passivation film layer according to claim 1, **characterized in that** a silicon oxide layer is disposed between the silicon substrate and the first silicon nitride layer.

8. The solar cell front passivation film layer according to claim 7, **characterized in that** the silicon oxide layer has a thickness of 3 nm to 15 nm.

9. The solar cell front passivation film layer according to claim 1, **characterized in that** a third silicon nitride layer is disposed between the second silicon nitride layer and the silicon oxynitride layer.

10. The solar cell front passivation film layer according to claim 9, **characterized in that** the third silicon nitride layer has a refractive index of 1.8 to 2.05 and a thickness of 15 nm to 40 nm.
